# EUROPEAN PATENT SPECIFICATION

(11) **EP 2 219 863 B1**
(45) Date of publication and mention of the grant of the patent: **20.03.2013**
(21) Application number: 08862657.7
(22) Date of filing: 11.12.2008
(51) Int. Cl.: B32B 17/10, B32B 27/06, B32B 27/32, B32B 27/08, H01L 31/048

(54) **ACID TERPOLYMER FILMS OR SHEETS AND ARTICLES COMPRISING THE SAME**
FOLIEN ODER FILME AUS SÄURETERPOLYMEREN SOWIE DIESE UMFASSENDE GEGENSTÄNDE
FILMS DE TERPOLYMÈRE ACIDE OU FEUILLES ET ARTICLES LES COMPRENANT

(30) Priority: 14.12.2007 US 957276
(43) Date of publication of application: 25.08.2010
(73) Proprietor: E. I. du Pont de Nemours and Company, Wilmington, DE 19898 (US)
(72) Inventor: HAYES, Richard, Allen, Beaumont Texas 77706 (US); SAMUELS, Sam, Louis, Landenberg Pennsylvania 19350 (US)
(74) Representative: Dannenberger, Oliver Andre
(86) International application number: PCT/US2008/086359
(87) International publication number: WO 2009/079321

(56) References cited:
- EP-A- 1 065 731
- WO-A-97/06005
- WO-A-99/04971
- WO-A-2007/027861
- WO-A-2007/094815
- WO-A-2008/013837
- WO-A-2008/100611
- WO-A-2008/100612
- WO-A-2009/002813
- US-A1- 2007 154 694

## Description

The present invention relates to a solar cell pre-lamination assembly.

### BACKGROUND OF THE INVENTION

Glass laminated products, such as safety glass, have contributed to society for almost a century. Safety glass also found uses in structural, decorative or other architectural applications.

Safety glass typically consists of a sandwich of two glass sheets or panels bonded together with a polymeric interlayer of a polymeric sheet. One or both of the glass sheets may be replaced with optically clear rigid polymeric sheets, such as sheets of polycarbonate materials. Safety glass has further evolved to include multiple layers of glass and/or rigid polymeric sheets bonded together with interlayers.

The interlayer is typically made with a relatively thick polymer sheet, which exhibits toughness and bondability to provide adhesion to the glass in the event of a crack or crash. Widely used interlayer materials include complex, multicomponent compositions based on poly(vinyl butyral) (PVB), poly(urethane) (PU), poly(ethylene-co-vinyl acetate) (EVA), and the like.

As a sustainable energy resource, the use of solar cell modules is rapidly expanding. One preferred way of manufacturing a solar cell module involves forming a pre-lamination assembly comprising at least 5 structural layers. The solar cell pre-lamination assemblies are constructed in the following order starting from the top, or incident layer (that is, the layer first contacted by light) and continuing to the backing layer (the layer furthest removed from the incident layer): (1) incident layer (typically a glass plate or a thin polymeric film (such as a fluoropolymer or polyester film), but could conceivably be any material that is transparent to sunlight), (2) front encapsulant layer, (3) solar cell component, (4) back encapsulant layer, and (5) backing layer.

The encapsulant layers are designed to encapsulate and protect the fragile solar cell component. Generally, a solar cell pre-lamination assembly incorporates at least two encapsulant layers sandwiched around the solar cell component. The optical properties of the front encapsulant layer may be such that light can be effectively transmitted to the solar cell component. Additionally, encapsulant layers generally have similar requirements and compositions to that described above for safety glass interlayers.

The use of acid copolymers of a-olefins and α,β-ethylenically unsaturated carboxylic acids in forming safety glass interlayers has been known within the art (see, e.g., U.S. Pat No. 3,762,988). The use of such acid copolymers in forming solar cell encapsulant layers has been disclosed in, e.g., U.S. Pat Nos. 5,508,205; 6,187,448; 6,320,116; 6,414,236; 6,586,271; 6,693,237; and 6,777,610, U.S. Pat Appl Nos. 200410191422 and 2006/0207645, European Pat No. 1544921, Japanese Pat Nos. JP 2000186114; JP 2001089616; JP 2001119047; JP 2001119056; JP 2001119057; JP 2001144313; JP 2001261904; JP 2001332751; and JP 2002335005; JP 2004031445; JP 2004058583; JP 2006032308; JP 2006036875; and JP 2006190867, and PCT Pat Appl No. WO 031041177.

Acid terpolymers of α-olefins, α,β-ethylenically unsaturated carboxylic acids, and α,β-ethylenically unsaturated carboxylic acid esters have also been used in forming safety glass interlayers (see e.g., U.S. Pat Appl No. 2001/0008695) or solar cell encapsulant layers (see e.g., U.S. Pat Nos. 3,957,537 and 6,414,236, and Japanese Pat Nos. JP 2004031445 and JP 2004058583).

However, safety glass interlayers and solar cell encapsulant layers formed of such acid copolymers are lack of adequate light transmission properties and sufficient adhesion strength to other laminate layers, especially under severe environmental conditions. Moreover, the solar cell encapsulant layers formed of such acid copolymers often fail to provide adequate protection to the solar cell component from shock. On the other hand, safety glass interlayers and solar encapsulant layers formed of the acid terpolymers taught by the prior art also do not have the desired light transmission property and adhesion strength to other laminate layers.

WO 2008/013837 A discloses a solar cell module comprising at least one layer made of ionomers.

WO 2008/100611 A and WO 20081100612 A relate to solar cell modules containing high melt flow acid copolymer compositions or ionomeric copolymers.

WO 97/06005 A relates to laminated safety glass comprising films or sheets comprising ionomer compositions.

WO 2007/027861 A discloses a solar control laminate comprising a solar control film and a polymeric sheet, wherein the solar control film comprises a polymeric film coated with a coating comprising inorganic infrared absorbing nanoparticles. Compositions comprising infrared absorptive inorganic nanoparticles, and an ethylene copolymer used in solar control laminates are also disclosed in WO 2D07/094815 A.

US 2007/154694 A1 provides for high-strength multilayer polymeric laminates having improved acoustic barrier properties. These laminates may also comprise glass used for solar control purposes.

WO 99/04971 A relates to an encapsulant material including a layer of metallocene polyethylene disposed between two layers of an acid copolymer of polyethylene. The encapsulant material can be used in solar cell module applications.

EP 1 065 731 A discloses a solar cell module wherein a photovoltaic element is sealed by organic polymeric resin layers, at least one of which contains a specific ethylene-unsaturated fatty acid ester-unsaturated fatty acid terpolymer.

There is a need for polymeric films or sheets suitable as solar cell encapsulant layers, which are transparent and highly adhesive to other Laminate layers.

### SUMMARY OF THE INVENTION

The invention is directed to a solar cell pre-lamination assembly comprising a film or sheet comprising or made of an acid terpolymer composition, wherein the acid terpolymer comprises copolymerized units derived from an α-olefin, 15 to 30 wt% of an α,β-ethylenically unsaturated carboxylic acid having 3 to 8 carbons, and 0.5 to 40 wt% of an α,β-ethylenically unsaturated carboxylic acid ester having 4 to 12 carbons, based on the total weight of the acid terpolymer; and a solar cell component formed of one or a plurality of electronically interconnected solar cells and having a light-receiving side that faces a light source and a back side that is opposite from the light source; provided that the acid terpolymer does not have a Melt Index of 75 to 600 g/10 min as measured by ASTM D1238 at 190°C and a 2160 g load.

The invention is further directed to a process comprising:
(i) providing a solar cell pre-lamination assembly as described above and
(ii) laminating the assembly to form a solar cell module.

The invention is yet further directed to a solar cell module produced from the solar cell pre-lamination assembly as described above.

### DETAILED DESCRIPTION OF THE INVENTION

The term "acid copolymer refers to a polymer comprising copolymerized units derived from an α-olefin, an α,β-ethylenically unsaturated carboxylic acid.

The term "ionomer refers to a polymer that is derived from a parent acid copolymer, as disclosed above, by partially or fully neutralizing the parent acid copolymer.

### Acid Terpolymer Films and Sheets

The invention uses a film or sheet (which may be a single-layer or a multilayer film or sheet) comprising an acid terpolymer composition for providing a lamination article comprising the same, wherein the acid terpolymer comprises copolymerized units derived from an α-olefin having 2 to 10 carbons, 15 to 30 wt% of an α,β-ethylenically unsaturated carboxylic acid having 3 to 8 carbons, and 0.5 to 40 wt% of an α,β-ethylenically unsaturated carboxylic acid ester having 4 to 12 carbons, based on the total weight of the terpolymer.

Preferably, the acid terpolymer comprises 18 to 25 wt%, or 18 to 23 wt%, of copolymerized units of the α,β-ethylenically unsaturated carboxylic acid. Preferably, the acid terpolymer comprises 0.5 to 5 wt%, or 15 to 40 wt%, or 15 to 25 wt% of copolymerized units of the α,β-ethylenically unsaturated carboxylic acid ester

The α-olefin comonomers may include, but are not limited to, ethylene, propylene, 1-butene, 1-pentene, 1-hexene, 1-heptene, 3 methyl-1-butene, 4-methyl-1-pentene, and the like and mixtures of two or more thereof. Preferably, the α-olefin is ethylene.

The α,β-ethylenically unsaturated carboxylic acid comonomers may include, but are not limited to, acrylic acids, methacrylic acids, itaconic acids, maleic acids, maleic anhydrides, fumaric acids, monomethyl maleic acids, and mixtures of two or more thereof. Preferably, the α,β-ethylenically unsaturated carboxylic acid is selected from acrylic acids, methacrylic acids, and mixtures of two or more thereof.

The α,β-ethylenically unsaturated carboxylic acid ester comonomers may include, but are not limited to, methyl acrylates, methyl methacrylates, ethyl acrylates, ethyl methacrylates, isopropyl acrylates, isopropyl methacrylates, butyl acrylates, butyl methacrylates, and mixtures of two or more thereof. Preferably, the α,β-ethylenically unsaturated carboxylic acid ester is selected from methyl acrylates and butyl acrylates.

The acid terpolymers may be polymerized as disclosed in U.S. Pat Nos. 3,404,134; 5,028,674; 6,500,888; and 6,518,365.

A most preferred acid terpolymer is poly(ethylene-co-butyl acrylate-co-methacrylic acid).

The acid terpolymer compositions may further comprise any suitable additives known within the art including plasticizers, processing aides, lubricants, flame retardants, impact modifiers, nucleating agents, antiblocking agents (e.g., silica), thermal stabilizers, UV absorbers, UV stabilizers, dispersants, surfactants, chelating agents, coupling agents, adhesives, primers, the like, or mixtures of two or more thereof. The total amount of additives comprised in an acid terpolymer composition may be from 0.001 up to 5 wt%, based on the total weight of the composition.

The acid terpolymer composition optionally further comprises one or morse silane coupling agents to further enhance the adhesion strength of the film or sheet comprising the same. Exemplary coupling agents include, but are not limited to, γ-chloropropylmethoxysilane, vinyltrimethoxysilane, vinyltriethoxysilane, vinyltris(β-methoxyethoxy)silane, γ-vinylbenzylpropyltrimethoxysilane, N-β-(N-vinylbenzylaminoethyl)-γ-aminopropyltrimethoxysilane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropylmethoxysilane, γ-aminopropyltriethoxysilane, N-β-(aminoethyl)-γ-aminopropyltrimethoxysilane, and the like and mixtures of two or more thereof. The silane coupling agents are preferably present in the acid terpolymer composition at a level of 0.01 to 5 wt%, or 0.05 to 1 wt%, based on the total weight of the composition. The adhesion promoting agents may also be absent from the acid terpolymer compositions, especially when they are comprised in the surface sub-layers of the films or sheets.

The acid terpolymer compositions optionally further comprises additives to reduce the melt flow of the resin, to the limit of thermosetting the films or sheets derived therefrom during lamination and therefore provide lamination products comprising the same with even greater thermal resistance and fire resistance. By the addition of such additives, the end-use temperature may be enhanced by 20°C to 70°C. Typically, the effective melt flow reducing additives are organic peroxides, such as 2,5-dimethylhexane-2,5-dihydroperoxide, 2,5-dimethyl-2,5-di(tert-betylperoxy)hexane-3, di-tert-butyl peroxide, tert-butylcumyl peroxide, 2,5-dimethyl-2,5-di(tert-butylperoxy)hexane, dicumyl peroxide, α,α'-bis(tert-butyl-peroxyisopropyl)benzene, n-butyl-4,4-bis(tert-butylperoxy)valerate, 2,2-bis(tert-butylperoxy)butane, 1,1-bis(tert-butyl-peroxy)cyclohexane, 1,1-bis(tert-butylperoxy)-3,3,5-trimethyl-cyclohexane, tert-butyl peroxybenzoate, benzoyl peroxide, and the like and mixtures or combinations thereof. The organic peroxides may decompose at a temperature of about 100°C or higher to generate radicals or have a decomposition temperature which affords a half life of 10 hours at about 70°C or higher to provide improved stability for blending operations. The organic peroxides may be added at a level of 0.01 to 10 wt%, or 0.5 to 3.0 wt%, based on the total weight of the composition. The flow reducing additives may also be absent from the acid terpolymer composition to provide sufficient polymeric flow during lamination and sufficient adhesion to other laminate layers.

If desired, initiators, such as dibutyltin dilaurate, may be contained in the acid terpolymer compositions at a level of 0.01 to 0.05 wt%, based on the total weight of the composition. In addition, if desired, inhibitors, such as hydroquinone, hydroquinone monomethyl ether, p-benzoquinone, and methylhydroquinone, may be added to the acid terpolymer compositions at a level of less than about 5 wt%, based on the total weight of the composition.

The acid terpolymer containing film or sheet may be in a single-layer form or a multilayer form. Single-layer has only one single layer that is made of the acid terpolymer composition. Preferably, the acid terpolymer film or sheet is a multilayer film or sheet having two surface sub-layers and optionally one or more inner sub-layers with at least one of the sub-layers comprising or made of the acid terpolymer composition. The term "surface sub-layers" refers to the two sub-layers forming the two outer surfaces of the multilayer film or sheet and the term "inner sub-layer(s)" refers to the sub-layer(s) sandwiched between the two surface sub-layers. More preferably, the acid terpolymer film or sheet is a multilayer film or sheet having at least one of the two surface sub-slayers comprising or made of the acid terpolymer composition.

When the acid terpolymer containing film or sheet is in a multilayer form, the other non-acid terpolymer-containing sub-layer(s) may be formed of any other suitable polymer compositions comprising polymeric materials selected from acid copolymers, ionomers, poly(ethylene-co-vinyl acetates), poly(vinyl acetals) (e.g., poly(vinyl butyrals)), thermoplastic polyurethanes, poly(vinyl chlorides), polyethylenes (e.g., metallocene-catalyzed linear low density polyethylenes), polyolefin block elastomers, poly(α-olefin-co-α,β-ethylenically unsaturated carboxylic acid ester) copolymers (e.g., poly(ethylene-co-methyl acrylate) and poly(ethylene-co-butyl acrylate)), silicone elastomers, epoxy resins, and mixtures of two or more thereof. Preferably, the other sub-layer(s) comprise or are made of ionomers derived from acid copolymers that comprise copolymerized units of α-olefins, α,β-ethylenically unsaturated carboxylic acids, and optionally α,β-ethylenically unsaturated carboxylic acid esters, and are neutralized to a level of 1% to 90%, or 10% to 40% with one or more metal ions, such as zinc, magnesium, lithium, and mixtures of two or more thereof. The preferred metal ion is zinc. More preferably, the other sub-layer(s) are made of ionomers having a melting point of at least about 80°C, or at least about 90°C, or at least about 95°C to provide excellent creep resistance when the film or sheet is used in lamination articles. Specific examples of such ionomeric compositions include those Surlyn^{®} products available from E. I. du Pont de Nemours and Company, Wilmington, DE (DuPont). Most preferably, the acid terpolymers containing film or sheet is a multilayer film or sheet comprising two surface sub-layers both comprising or made of the acid terpolymer composition disclosed here and at least one inner sub-layer comprising or made of the above mentioned ionomer with high melting point.

The acid terpolymer containing film or sheet may have a total thickness of 2 mils (0.051 mm) to 250 mils (6.35 mm). When in a multilayer form, each of the acid terpolymer containing sub-layer(s) may have a thickness of 0.5 mils (0.013 mm) to 5 mils (0.13 mm), or 0.5 mils to 3 mils (0.076 mm), and each of the other sub-layer(s) may have a thickness of 0.5 mils (0.013 mm) to 120 mils (3 mm), or 10 mils (0.25 mm) to 90 mils (2.28 mm), or 30 mils (0.76 mm) to 60 mils (1.52 mm).

When the acid terpolymer film or sheet is comprised in a solar cell module as an encapsulant layer, it is preferred to have a total thickness of 2 mils (0.051 mm) to 20 mils (0.51 mm). In addition, with flexible solar cell laminates, it is preferred to have at least one encapsulant layer formed of a thin acid terpolymer film as disclosed above, which has a thickness of 2 mils (0.051 mm) to 10 mils (0.25 mm), or 2 mil (0.051 mm) to 5 mils (0.13 mm), and with rigid solar cell laminates, it is preferred to have at least one encapsulant layer formed of a thick acid terpolymer sheet as disclosed above, which has a thickness of 10 mils (0.25 mm) to 20 mils (0.51 mm).

The acid terpolymer films or sheets may have smooth or rough surfaces on one or both sides. Preferably, the films or sheets have rough surfaces on both sides to facilitate the deareation of the laminates during the laminate process. Rough surfaces can be made by mechanically embossing or by melt fracture during extrusion of the films or sheets followed by quenching so that the roughness is retained during handling. The surface pattern can be applied to the acid terpolymer film or sheet through common art processes. For example, the as-extruded film or sheet may be passed over a specially prepared surface of a die roll positioned in close proximity to the exit of the die which imparts the desired surface characteristics to one side of the molten polymer. Thus, when the surface of such a die roll has minute peaks and valleys, the polymer film or sheet cast thereon will have a rough surface on the side which contacts the roll which generally conforms respectively to the valleys and peaks of the roll surface. Such die rolls are disclosed in, e.g., U.S. Pat No. 4,035,549, U.S. Pat Appl Nos. 200310124296 and 2008/0286530.

The acid terpolymer films or sheets can be produced by any suitable process. For example, the films or sheets may be formed through dipcoating, solution casting, compression molding, injection molding, lamination, melt extrusion, blown film, extrusion coating, tandem extrusion coating, or any other procedures that are known to those of skill in the art. Preferably, the films or sheets are formed by melt coextrusion, melt extrusion coating, or tandem melt extrusion coating processes.

The acid terpolymer film or sheet has a percent transmission of 80% to 100%, as measured by ASTM D1003. Preferably, the acid terpolymer film or sheet has a percent transmission of 90% to 100% transmission. In addition, it desirably provides a percent clarity of 90% to 100%, or 95% to 100%, or 98% to 100%, as measured by ASTM D1003.

### Articles

The invention provides a pre-lamination or lamination article (e.g., a solar cell pre-lamination assembly, or a solar cell module derived therefrom) comprising at least one layer of the acid terpolymer containing film or sheet disclosed herein.

The use of such acid terpolymer containing films or sheets in solar cell modules provides advantages over other prior art polymeric films or sheet. First, the acid terpolymer containing film or sheet has enhanced adhesion strength to other laminate layers, especially after severe environmental aging. For example, the enhanced adhesion strength can be shown after the laminate has undergone a damp heat test at 85°C and 85% relative humidity for 1000 hours, or a thermal cycling test in accordance to the international Electrotechnical Commission (IEC) test method 16215, sections 10-11 and/or 10-12. Specifically, the adhesion strength between the acid terpolymer containing film or sheet and its adjacent laminate layer(s) may be measured by a 180° peel strength test using an Instron^{®} Model # 1125 (1000 lb (454 kg) test frame) Tester in accordance to ASTM D903 as modified with a cross-head speed of 100 mm/min. In accordance to the invention, at least about 50%, or at least about 60%, or at least about 75%, of the 180° peel strength between the acid terpolymer containing film or sheet and its adjacent layer(s) is maintained after the lamination article has been conditioned for 1000 hours at a temperature of about 85°C and a relative humidity of about 85%. Secondly, in those embodiments where the acid terpolymers comprise about 0.5 to about 5 wt% of copolymerized units of the α,β-ethylenically unsaturated carboxylic acid esters, the acid terpolymer containing films or sheets further exhibit improved shock resistance, and in those embodiments where the acid terpolymers comprise 15 to 40 wt%, or 15 to 25 wt% of copolymerized units of the α,β-ethylenically unsaturated carboxylic acid esters, the acid terpolymer containing films or sheets further exhibit improved transparency.

Further described herein is a safety laminate including a polymeric interlayer comprising a layer of the above disclosed acid terpolymer film or sheet.

The polymeric interlayer optionally further comprises one or more other interlayer films or sheets made of other suitable polymeric materials. Such optional other interlayer sheets may be made of polymeric materials selected from acid copolymers, ionomers, poly(ethylene-co-vinyl acetates), poly(vinyl acetals) (including acoustic grade poly(vinyl acetals)), polyurethane, poly(vinyl chlorides), polyethylenes (e.g., metallocene-catalyzed low density polyethylenes), polyolefin block elastomers, ethylene acrylate ester copolymers (e.g., poly(ethylene-co-methyl acrylate) and poly(ethylene-co-butyl acrylate)), silicone elastomers, epoxy resins, and mixtures of two or more thereof. Such optional other interlayer films may be made of polymeric materials selected from polyesters (e.g., poly(ethylene terephthalate) and poly(ethylene naphthalates)), polycarbonates, polyolefins (e.g., polypropylene, polyethylene, and cyclic polyolefins), norbornene polymers, polystyrenes (including syndiotactic polystyrenes), styrene-acrylate copolymers, acrylonitrile-styrene copolymers, polysulfones (e.g., polyethersulfone, polysulfone, etc.), nylons, poly(urethanes), acrylics, cellulose acetates (e.g., cellulose acetate, cellulose triacetates, etc.), cellophanes, vinyl chloride polymers (e.g., poly(vinylidene chloride)), fluoropolymers (e.g., polyvinyl fluoride, polyvinylidene fluoride, polytetrafluoroethylene, ethylene-tetrafluoroethylene copolymers, etc.) and mixtures of two or more thereof. The optionally other interlayer films may also be coated if desired. For example, the films may be coated with organic infrared absorbers and sputtered metal layers, such as silver, coatings and the like. Metal coated polymeric films are disclosed in, e.g., U.S. Pat Nos. 3,718,535; 3,816,201; 4,465,736; 4,450,201; 4,799,745, 4,846,949; 4,954,383; 4,973,511; 5,071,206; 5,306,547; 6,049,419; 6,104,530; 6,204,480; 6,255,031; and 6,565,982. For examples, the coating may function as oxygen and moisture barrier coatings, such as the metal oxide coating disclosed within U.S. Patent Nos. 6,521,825 and 6,818,819 and European Pat No. EP1182710.

The thickness of the other optional interlayer film(s) may range from 0.1 mil (0.003 mm) to 10 mils (0.26 mm), or preferably, from 1 mil (0.025 mm) to 7 mils (0.18 mm), the thickness of the other optional interlayer sheet(s) may be 10 mils (0.25 mm) to 250 mils (6.35 mm), or 15 mils (0.38 mm) to 90 mils (2.28 mm), or 30 mils (0.76 mm) to 60 mils (1.52 mm), and the total thickness of all the component films or sheets in the interlayer does not exceed 250 mils (6.35 mm).

The laminate may further comprise an outer layer bonded to one side of the interlayer, or two outer layers bonded to each side of the interlayer where each outer layer may be a rigid sheet or a polymeric film.

The rigid sheets include glass sheets and rigid polymeric sheets having a thickness of 10 mils (0.25 mm) to 250 mils (6.35 mm) including, but not limited to, polycarbonates, acrylics, polyacrylates, cyclic polyolefins (e.g., ethylene norbornene polymers), polystyrenes (preferably metallocene-catalyzed polystyrenes), polyamides, polyesters, fluoropolymers and the like and combinations of two or more thereof. Preferably, the rigid polymeric sheets are made of polymeric materials having a modulus of at least 10,000 psi (69 MPa)

Glass includes not only window glass, plate glass, silicate glass, sheet glass, low iron glass, tempered glass, tempered CeO-free glass, and float glass, but also to include colored glass, specialty glass (such as those include ingredients to control, e.g., solar heating), coated glass (such as those sputtered with metals (e.g., silver or indium tin oxide) for solar control purposes), E-glass, Toroglass, Solex^{®} glass (PPG Industries, Pittsburgh, PA). Such specialty glasses are disclosed in, e.g., U.S. Pat Nos. 4,615,989; 5,173,212; 5,264,286; 6,150,028; 6,340,646; 6,461,736; and 6,468,934. The type of glass to be selected for a particular laminate depends on the intended use.

The polymeric films are preferably made of materials selected from polyesters (e.g., poly(ethylene terephthalate) and poly(ethylene naphthalates)), polycarbonates, polyolefins (e.g., polypropylenes, polyethylenes, and cyclic polyloefins), norbornene polymers, polystyrenes (e.g., syndiotactic polystyrenes), styrene-acrylate copolymers, acrylonitrile styrene copolymers, polysulfones (e.g., polyethersulfones, polysulfones, etc.), nylons, poly(urethanes), acrylics, cellulose acetates (e.g., cellulose acetates, cellulose triacetates, etc.), cellophanes, poly(vinyl chlorides) (e.g., poly(vinylidene chlorides)), fluoropolymers (e.g., polyvinyl fluorides, polyvinylidene fluorides, polytetrafluoroethylenes, ethylene-tetrafluoroethylene copolymers, etc.), and the like or combinations of two or more thereof. More preferably, the polymeric films are polyester films, or most preferably, bi-axially oriented poly(ethylene terephthalate) films. Preferably, the polymeric films are hardcoated on the outside surface. By "hardcoated", it is meant that a clear anti-scratch and anti-abrasion hardcoat is coated on the outside surface of the polymeric film, with the outside surface being the surface that is further away from the interlayer of the safety laminate. Hardcoat may comprise or be produced from polysiloxanes or cross-linked (thermosetting) polyurethanes. Also applicable herein are the oligomeric-based coatings disclosed in U.S. Pat Appl No. 2005/0077002, which compositions are prepared by the reaction of (A) hydroxyl-containing oligomer with isocyanate-containing oligomer or (B) anhydride-containing oligomer with epoxide-containing compound. Preferably, the hardcoat are formed of polysiloxane abrasion resistant coatings (PARC), such as those disclosed in U.S. Pat Nos. 4,177,315; 4,469,743; 5,415,942; and 5,763,089.

Prior to applying the hardcoat, the outside surface of the polymeric film may need to undergo adhesion enhancing treatment as disclosed below.

The polymeric films may also have a solar control material coated on one or both of its surfaces. Solar control materials may be infrared absorbing materials, such as metal oxide nanoparticles (e.g., antimony tin oxide nanoparticles, indium tin oxide nanoparticles, or combinations thereof), metal boride nanoparticles (e.g., lanthanum hexaboride nanoparticles), or combinations of two or more thereof. The polymeric films may also be coated with an infrared energy reflective layer, such as a metal layer, a Fabry-Perot type interference filter layer, a layer of liquid crystals, or combinations of two or more thereof.

If desired, one or both surfaces of the laminate layers, such as the acid terpolymer film(s) or sheet(s) disclosed herein, the optional other interlayer sheet(s) or film layer(s), the rigid sheet(s), or the polymeric film(s), may be treated to further enhance the adhesion to other laminate layers. This adhesion enhancing treatment may take any form known within the art and include flame treatments (see, e.g., U.S. Pat Nos. 2,632,921; 2,648,097; 2,683,894; and 2,704,382), plasma treatments (see e.g., U.S. Pat No. 4,732,814), electron beam treatments, oxidation treatments, corona discharge treatments, chemical treatments, chromic acid treatments, hot air treatments, ozone treatments, ultraviolet light treatments, sand blast treatments, solvent treatments, and the like and combinations of two or more thereof. Also, the adhesion strength may be further improved by further applying an adhesive or primer coating on the surface of laminate layer(s). For example, U.S. Pat. No. 4,865,711 discloses a film or sheet with improved bondability, which has a thin layer of carbon deposited on one or both surfaces. Other exemplary adhesives or primers may include silanes, poly(allyl amine) based primers (see e.g., U.S. Pat Nos. 5,411,845; 5,770,312; 5,690,994; and 5,698,329), and acrylic based primers (see e.g., U.S. Pat No. 5,415,942). The adhesive or primer coating may take the form of a monolayer of the adhesive or primer and have a thickness of 0.0004 to 1 mil (0.00001 to 0.03 mm), or preferably, 0.004 to 0.5 mil (0.0001 to 0.013 mm), or more preferably, 0.004 to 0.1 mil (0.0001 to 0.003 mm).

The adhesives or primers coating may be 0.0004 mil (0.00001 mm) to 1 mil (0.03 mm), or 0.004 mil (0.0001 mm) to 0.5 mil (0.013 mm), or 0.004 mil (0.0001 mm) to 0.1 mil (0.003 mm) thick.

The acid terpolymer films and sheets may also not undergo any adhesion enhancing treatment and are self-adhered to the other laminate layers.

The safety laminate may take any form known within the art. Preferable specific glass laminate constructions include:
- glass/ATR;
- glass/ATR/film (e.g., hardcoated poly(ethylene terephthalate) film);
- glass/ATR/g lass;
- film/ATR/film;
- glass/ATR/film/ATR/glass;
- glass/ATR/film/ATR/film,
and the like, wherein "ATR" stands for the acid terpolymer film or sheet disclosed above.

The safety laminates may be produced by any of the lamination process that are described below in detail, or by other processes known to one skilled in the art.

The solar cell pre-lamination assembly of the present invention comprises a solar cell component formed of one or a plurality solar cells and at least one layer of the acid terpolymer film or sheet described above.

Solar cell is meant to include any article which can convert light into electrical energy. Typical art examples of the various forms of solar cells include, for example, single crystal silicon solar cells, polycrystal silicon solar cells, microcrystal silicon solar cells, amorphous silicon based solar cells, copper indium selenide solar cells, compound semiconductor solar cells, dye sensitized solar cells, and the like. The most common types of solar cells include multi-crystalline solar cells, thin film solar cells, compound semiconductor solar cells and amorphous silicon solar cells.

Thin film solar cells are typically produced by depositing several thin film layers onto a substrate, such as glass or a flexible film, with the layers being patterned so as to form a plurality of individual cells which are electrically interconnected to produce a suitable voltage output. Depending on the sequence in which the multi-layer deposition is carried out, the substrate may serve as the rear surface or as a front window for the solar cell module. By way of example, thin film solar cells are disclosed in U.S. Pat Nos. 5,512,107; 5,948,176; 5,994,163; 6,040,521; 6,137,048; and 6,258,620.

The solar cell pre-lamination assembly typically comprises at least one layer of the acid terpolymer film or sheet, which is positioned next to the solar cell component and serves as one of the encapsulant layers, or preferably, the acid terpolymer film or sheet is positioned next to the solar cell component to the light-receiving side and serves as the front encapsulant layer.

The solar cell pre-lamination assembly may further comprise encapsulant layers formed of other polymeric materials, such as, acid copolymers, ionomers, ethylene vinyl acetates, poly(vinyl acetals) (including acoustic grade poly(vinyl acetals), polyurethanes, polyvinylchlorides, polyethylenes (e.g., linear low density polyethylenes), polyolefin block elastomers, poly(α-olefin-co-α,β-ethylenically unsaturated carboxylic acid ester) copolymers (e.g., poly(ethylene-co-methyl acrylate) and poly(ethylene-co-butyl acrylate)), silicone elastomers, epoxy resins, and combinations of two or more thereof. Preferably, the solar cell pre-lamination assembly comprises two layers of the acid terpolymer film or sheet, wherein each of the two acid terpolymer films or sheets are laminated to each of the two sides of the solar cell component and serve as the front and back encapsulant layers.

The thickness of the individual encapsulant layers other than the acid terpolymer film(s) or sheet(s) may independently range from 1 mil (0.026 mm) to 120 mils (3 mm), or from 1 mil to 40 mils (1.02 mm), or from 1 mil to 20 mils (0.51 mm). All the encapsulant layer(s) comprised in the solar cell pre-lamination assemblies, may have smooth or rough surfaces. Preferably, the encapsulant layer(s) have rough surfaces to facilitate the deareation of the laminates through the lamination process.

The solar cell pre-lamination assembly may yet further comprise an incident layer and/or a backing layer serving as the outer layers of the assembly at the light-receiving side and the back side, respectively.

The outer layers of the solar cell pre-lamination assemblies, i.e., the incident layer and the backing layer, may be derived from any suitable sheets or films. Suitable sheets may be glass or plastic sheets, such as, polycarbonates, acrylics, polyacrylates, cyclic polyolefins (e.g., ethylene norbornene polymers), polystyrenes (preferably metallocene-catalyzed polystyrenes), polyamides, polyesters, fluoropolymers and the like and combinations of two or more thereof. In addition, metal sheets, such as aluminum, steel, galvanized steel, or ceramic plates may be utilized in forming the backing layer. Suitable films may be made of polymers selected from polyesters (e.g., poly(ethylene terephthalates) and poly(ethylene naphthalates)), polycarbonates, polyolefins (e.g., polypropylenes, polyethylenes, and cyclic polyolefins), norbornene polymers, polystyrenes (e.g., syndiotactic polystyrenes), styrene-acrylate copolymers, acrylonitrile-styrene copolymers, polysulfones (e.g., polyethersulfones, polysulfones, etc.), nylons, poly(urethanes), acrylics, cellulose acetates (e.g., cellulose acetate, cellulose triacetates, etc.), cellophanes, poly(vinyl chlorides) (e.g., poly(vinylidene chlorides)), fluoropolymers (e.g., polyvinyl fluorides, polyvinylidene fluorides, polytetrafluoroethylenes, ethylene-tetrafluoroethylene copolymers, etc.) and the like, or combinations of two or more thereof. The polymeric film may be bi-axially oriented polyester film (preferably poly(ethylene terephthalate) film) or a fluoropolymer film (e.g., Tedlar^{®}, Tefzel^{®}, and Teflon^{®} films, from DuPont). TPT films are also preferred for some applications. Metal films, such as aluminum foil may also be used as the back-sheet.

The solar cell pre-lamination assembly may further comprise other functional film or sheet layers (e.g., dielectric layers or barrier layers) embedded within the assembly. Such functional layers may be derived from any of the above mentioned polymeric films or those that are coated with additional functional coatings. For example, poly(ethylene terephthalate) films coated with a metal oxide coating, such as those disclosed within U.S. Pat Nos. 6,521,825 and 6,818,819, and European Pat No. EP1182710, may function as oxygen and moisture barrier layers in the laminates.

If desired, a layer of non-woven glass fiber (scrim) may also be included in the solar cell laminates to facilitate deareation during the lamination process or to serve as reinforcement for the encapsulant layer(s). The use of such scrim layers within solar cell laminates is disclosed within, e.g., U.S. Pat Nos. 5,583,057; 6,075,202; 6,204,443; 6,320,115; and 6,323416, and European Pat No. EP0769818.

The film or sheet layers positioned to the light-receiving side of the solar cell component may be made of transparent material to allow efficient transmission of sunlight into the solar cell component. A special film or sheet may be included to serve both the function of an encapsulant layer and an outer layer. It is also conceivable that any of the film or sheet layers included in the assembly may be in the form of a pre-formed single-layer or multilayer film or sheet.

If desired, one or both surfaces of the laminate layer(s) of the solar cell pre-lamination assembly, such as the acid terpolymer containing film(s) or sheet(s), may be treated to enhance the adhesion strength, as described above.

The acid terpolymer films and sheets may also not undergo any adhesion enhancing treatment and are self-adhered to the other laminate layers.

The solar cell pre-lamination assemblies may take any form known within the art. Preferable specific solar cell pre-lamination constructions (top (light receiving) side to back side) include,
• glass/ATR/solar cell/ATR/glass;
• glass/ATR/solar cell/ATR/fluoropolymer film (e.g., Tedlar^{®} film);
• fluoropolymer film/ATR/solar cell/ATR/glass;
• fluoropolymer film/ATR/solar cell/ATR/fluoropolymer film;
• glass/ATR/solar cell/ATR/polyester film (e.g., poly(ethylene terephthalate) film);
• fluoropolymer film/ATR/solar cell/ATWpolyester film;
• glass/ATR/solar cell/ATR/barrier coated film/ATR/glass;
• fluoropolymer film/ATR/barrier coated film/ATR/solar cell/ATR/barrier coated film/ATR/fluoropolymer film;
• glass/ATR/solar cell/ATR/aluminum stock;
• fluoropolymer film/ATR/solar cell/ATR/aluminum stock;
• glass/ATR/solar cell/ATR/galvanized steel sheet;
• glass/ATR/solar cell/ATR/polyester film/ATR/aluminum stock;
• fluoropolymer film/ATR/solar cell/ATR/polyester film/ATR/aluminum stock;
• glass/ATR/solar cell/ATR/polyester film/ATR/galvanized steel sheet;
• fluoropolymer film/ATR/solar cell/ATR/polyester film/ATR/galvanized steel sheet;
• glass/ATR/solar cell/poly(vinyl butyral) encapsulant layer/glass;
• glass/ATR/solar cell/poly(vinyl butyral) encapsulant layer/fluoropolymer film;
• fluoropolymer film/ATR/solar cell/acid copolymer encapsulant layer/fluoropolymer film;
• glass/ATR/solar cell/ethylene vinyl acetate encapsulant layer/polyester film;
• fluoropolymer film/ATR/solar cell/poly(ethylene-co-methyl acrylate) encapsulant layer/polyester film; and
• glass/poly(ethylene-co-butyl acrylate) encapsulant layer/solar cell/ATR/barrier coated film/poly(ethylene-co-butyl acrylate) encapsulant layer/glass,
and the like, wherein "ATR" stands for the acid terpolymer film or sheet. In addition, besides the Tedlar^{®} film from DuPont, suitable fluoropolymer films also include TPT trilayer films.

The invention further provides solar cell laminates derived from the solar cell pre-lamination assemblies disclosed above. Specifically, the solar cell laminates are formed by subjecting the solar cell pre-lamination assemblies to further lamination process, as provided below in detail.

### Lamination Process

Any lamination process know within the art may be used to prepare the safety glass laminates as described above or solar cell laminates according to the invention. The lamination process may be an autoclave or non-autoclave process.

In an exemplary process, the component layers of a safety glass laminate or a solar cell pre-lamination assembly are stacked up in the desired order to form a pre-lamination assembly. The assembly is then placed into a bag capable of sustaining a vacuum ("a vacuum bag"), the air is drawn out of the bag by a vacuum line or other means, the bag is sealed while the vacuum is maintained (e.g., 27 to 28 in Hg (689 to 711 mm Hg)), and the sealed bag is placed in an autoclave at a pressure of 150 to 250 psi (11.3 to 18.8 bar), a temperature of 130°C to 180°C, or 120°C to 160°C, or 135°C to 160°C, or 145°C to 155°C, for 10 to 50 minutes, or 20 to 45 minutes, or 20 to 40 minutes, or 25 to 35 minutes. A vacuum ring may be substituted for the vacuum bag. One type of suitable vacuum bag is disclosed within U.S. Pat No. 3,311,517. Following the heat and pressure cycle, the air in the autoclave is cooled without adding additional gas to maintain pressure in the autoclave. After about 20 minutes of cooling, the excess air pressure is vented and the laminates are removed from the autoclave.

Alternatively, the pre-lamination assembly may be heated in an oven at 80°C to 120°C, or 90°C to 100°C, for 20 to 40 minutes, and thereafter, the heated assembly is passed through a set of nip rolls so that the air in the void spaces between the individual layers may be squeezed out, and the edge of the assembly sealed. The assembly at this stage is referred to as a pre-press.

The pre-press may then be placed in an air autoclave where the temperature is raised to 120°C to 160°C, or 135°C to 160°C, at a pressure of 100 to 300 psi (6.9 to 20.7 bar), or about 200 psi (13.8 bar). These conditions are maintained for 15 to 60 minutes, or 20 to 50 minutes, and after which, the air is cooled while no more air is added to the autoclave. After 20 to 40 minutes of cooling, the excess air pressure is vented, the laminated products are removed from the autoclave.

The laminates may also be produced through non-autoclave processes. Such non-autoclave processes are disclosed, for examples, within U.S. Pat Nos. 3,234,062; 3,852,136; 4,341,576; 4,385,951; 4,398,979; 5,536,347; 5,853,516; 6,342,116; and 5,415,909, U.S. Pat Appl No. 200410182493, European Pat No. EP1235683 B1, and PCT Pat Appl Nos. WO91101880 and WO03/057478 A1. Generally, the non-autoclave processes include heating the pre-lamination assembly and the application of vacuum, pressure or both. For example, the assembly may be successively passed through heating ovens and nip rolls.

Essentially any lamination process may be used.

### EXAMPLES

The following Examples are intended to be illustrative of the present invention, and are not intended in any way to limit the scope of the present invention.

### Melt Index

Melt Index (MI) is measured by ASTM D1238 at 190°C using a 2160 g load.

### Melting Point

Melting point is measured by differential scanning calorimetry (DSC).

### Lamination Process 1

The component layers of the laminate are stacked to form a pre-lamination assembly. For the assembly containing a polymeric film layer as the outer surface layer, a cover glass sheet is placed over the film layer. The pre-lamination assembly is then placed within a Meier ICOLAM^{®} 10/08 laminator (Meier laminator; Meier Vakuumtechnik GmbH, Bocholt, Germany). The lamination cycle includes an evacuation step (vacuum of 3 in Hg (76 mm Hg)) of 5.5 minutes and a pressing stage (pressure of 1000 mbar) of 5.5 minutes at a temperature of 145°C. The resulting laminate is then removed from the laminator.

### Lamination Process 2

The component layers of the laminate are stacked to form a pre-lamination assembly. For the assembly containing a polymeric film layer as the outer surface layer, a cover glass sheet is placed over the film layer. The pre-lamination assembly is then placed within a vacuum bag, which is sealed and a vacuum is applied to remove the air from the vacuum bag. The bag is placed into an oven and heated to about 90°C to about 100°C for 30 minutes to remove any air contained between the assembly. The assembly is then subjected to autoclaving at 140°C for 30 minutes in an air autoclave to a pressure of 200 psig (14.3 bar). The air is cooled while no more air is added to the autoclave. After 20 minutes of cooling and when the air temperature reaches less than about 50°C, the excess pressure is vented, and the resulting laminate is removed from the autoclave.

### Materials

The following films and sheets are used in the examples:
• AL is a 3.2 mm thick aluminum sheet that is 5052 alloyed with 2.5 wt% of magnesium and conforms to Federal specification QQ-A-250/8 and ASTM B209;
• ATR 1 is a 30 mil (0.76 mm) thick embossed sheet made of Acid Terpolymer A, wherein Acid Terpolymer A is a poly(ethylene-co-n-butylacrylate-co-methacrylic acid) having a MI of 2.5 g/10 min and comprising, based on the total weight of the terpolymer, 2 wt% copolymerized units of n-butylacrylate and 19 wt% copolymerized units of methacrylic acid;
• ATR 2 is a 60 mil (1.52 mm) thick embossed tri-layer sheet having two 1 mil (0.03 mm) thick surface sub-layers made of a composition comprising, based on the total weight of the composition, 99.85 wt% of Acid Terpolymer B and 0.15 wt% of TINUVIN 328 (Ciba Specialty Chemicals, Tarrytown, NY) and an inner sub-layer made of lonomer A, wherein Acid Terpolymer B is a poly(ethylene-co-n-butylacrylate-co-methacrylic acid) having a MI of 10 g/10 min and comprising, based on the total weight of the terpolymer, 4 wt% copolymerized units of n-butylacrylate and 15 wt% copolymerized units of methacrylic acid; and lonomer A is derived from a poly(ethylene-co-methacrylic acid) that has a MI of 5 g/10 min, comprises, based on the total weight of the acid copolymer, 15 wt% copolymerized units of methacrylic acid, and is 70%, based on the total carboxylic acid content of the acid copolymer, neutralized with sodium;
• ATR 3 is a 15 mil (0.38 mm) thick embossed tri-layer sheet having two 1 mil (0.03 mm) thick surface sub-layers made of Acid Terpolymer C and an inner sub-layer made of a poly(ethylene-co-n-butyl acrylate) having a MI of 3 g/10 min and comprising, based on the total weight of the polymer, 35 wt% copolymerized units of n-butylacrylate, wherein Acid Terpolymer C is a poly(ethylene-co-n-butylacrylate-co-methacrylic acid) having a MI of 25 g/10 min and comprising, based on the total weight of the terpolymer, 15 wt% copolymerized units of n-butylacrylate and 22 wt% copolymerized units of methacrylic acid;
• ATR 4 is a 90 mil (2.25 mm) thick embossed tri-layer sheet having two 2 mil (0.06 mm) thick surface sub-layers made of Acid Terpolymer D and an inner sub-layer made of a poly(ethylene-co-methacrylic acid) that has a MI of 1.5 g/10 min, comprises, based on the total weight of the acid copolymer, 22 wt% copolymerized units of methacrylic acid, and is 35%, based on the total carboxylic acid content of the acid copolymer, neutralized with sodium, wherein Acid Terpolymer D is a poly(ethylene-con-butylacrylate-co-methacrylic acid) having a MI of 1 g/10 min and comprising, based on the total weight of the acid terpolymer, 20 wt% copolymerized units of n-butylacrylate and 18 wt% copolymerized units of methacrylic acid;
• ATR 5 is a 20 mil (0.51 mm) thick embossed bi-layer sheet having a first 1 mil (0.03 mm) thick sub-layer made of Acid Terpolymer E and a second sub-layer made of a poly(ethylene-co-methyl acrylate) having a MI of 5 g/10 min and comprising, based on the total weight of the polymer, 25 wt% copolymerized units of methyl acrylate, wherein Acid Terpolymer E is a poly(ethylene-co-n-butylacrylate-co-methacrylic acid) having a MI of 1 g/10 min and comprising, based on the total weight of the terpolymer, 1 wt% copolymerized units of n-butylacrylate and 23 wt% copolymerized units of methacrylic acid;
• ATR 6 is a 20 mil (0.51 mm) thick embossed sheet made of a composition comprising, based on the total weight of the composition, 99.5 wt% of Acid Terpolymer F and 0.5 wt% of CYASORB UV-1164 (Cytec Industries Inc., West Paterson, NJ), wherein Acid Terpolymer F is a poly(ethylene-co-methyl acrylate-co-methacrylic acid) having a MI of 5 g/10 min and comprising, based on the total weight of the terpolymer, 25 wt% copolymerized units of methyl acrylate and 15 wt% copolymerized units of methacrylic acid;
• ATR 7 is an 1 mil (0.03 mm) thick film made of Acid Terpolymer G, wherein Acid terpolymer G is a poly(ethylene-co-methyl acrylate-co-methacrylic acid) having a MI of 15 g/10 min and comprising, based on the total weight of the terpolymer, 5 wt% of copolymerized units of methyl acrylate and 18 wt% copolymerized units of methacrylic acid;
• ATR 8 is an 1 mil (0.03 mm) thick film made of Acid Terpolymer H, wherein Acid Terpolymer H is a poly(ethylene-co-n-butyl acrylate-co-methacrylic acid) having a MI of 2.5 g/10 min and comprising, based on the total weight of the terpolymer, 18 wt% copolymerized units of n-butyl acrylate and 20 wt% copolymerized units of methacrylic acid;
• ATR 9 is an 1 mil (0.03 mm) thick film made of a composition comprising, based on the total weight of the composition, 99.4 wt% of Acid Terpolymer C, 0.3 wt% of TINUVIN 1577 and 0.3 wt% of CHIMASSORB 944 (Ciba Specialty Chemicals);
• ATR 10 is a 20 mil (0.51 mm) thick embossed tri-layer sheet having two 1 mil (0.03 mm) thick surface sub-layers made of Acid Terpolymer G and an inner sub-layer made of lonomer A;
• ATR 11 is a 20 mil (0.51 mm) thick embossed tri-layer sheet having two 1 mil (0.03 mm) thick surface sub-layers made of Acid Terpolymer H and an inner sub-layer made of lonomer B;
• ATR 12 is a 20 mil (0.51 mm) thick embossed tri-layer sheet having two 1 mil (0.03 mm) thick surface sub-layers made of Acid Terpolymer C and an inner sub-layer made of lonomer A;
• EBA is a 30 mil (0.76 mm) thick sheet made of a poly(ethylene-con-butyl acrylate) containing, based on the total weight of the polymer, 30 wt% of copolymerized units of n-butyl acrylate and having a MI of 2 g/10 min;
• EVA is SC50B, believed to be a formulated composition based on poly(ethylene-co-vinyl acetate) in the form of a 20 mil thick (0.51 mm) sheet (Hi-Sheet Industries, Japan);
• FPF is a 1.5 mil (0.038 mm) thick corona surface treated Tedlar^{®} film (DuPont);
• Glass 1 is 2.5 mm thick float glass;
• Glass 2 is a 3.0 mm thick clear annealed float glass plate layer;
• Glass 3 is a 3.0 mm thick Solex^{®} solar control glass;
• Glass 4 is Starphire^{®} glass from the PPG Industries, Pittsburgh, PA;
• ION 1 is a 60 mil (1.52 mm) thick embossed sheet made of lonomer A, wherein lonomer A is derived from a poly(ethylene-co-methacrylic acid) that has a MI of approximately 2 g/10 min, comprises, based on the total weight of the acid copolymer, 22 wt% copolymerized units of methacrylic acid, and is approximately 27%, based on the total carboxylic acid content of the acid copolymer, neutralized with sodium;
• ION 2 is a 20 mil (0.51 mm) thick embossed sheet of lonomer B, wherein lonomer B is derived from a poly(ethylene-co-methacrylic acid) that has a MI of 2 g/10 min, comprises, based on the total weight of the acid copolymer, 19 wt% copolymerized units of methacrylic acid, and is 37%, based on the total carboxylic acid content of the acid copolymer, neutralized with zinc;
• PET 1 is a 7 mils (0.18 mm) thick poly(allyl amine)-primed, biaxially-oriented poly(ethylene terephthalate) film layer;
• PET 2 is a XIR^{®}-70 HP Auto film (Southwall Company, Palo Alto, CA);
• PET 3 is a XIR^{®}-75 Auto Blue V-1 film (Southwall);
• PET 4 is a Soft Look^{®} UV/IR 25 solar control film (Tomoegawa Paper Company, Ltd., Tokyo, Japan);
• PET 5 is a XIR^{®}-75 Green film (Southwall);
• PET 6 is RAYBARRIER^{®} TFK-2583 solar control film (Sumitomo Osaka Cement, Japan);
• PVB-A is a 20 mil thick (0.51 mm) embossed sheet of an acoustic grade of poly(vinyl butyral);
• PVB-B is B51V, believed to be a formulated composition based on poly(vinyl butyral) in the form of a 20 mil thick (0.51 mm) sheet (DuPont);
• Solar Cell 1 is a 10x10 in (254x254 mm) amorphous silicon photovoltaic device comprising a stainless steel substrate (125 µm thick) with an amorphous silicon semiconductor layer (see, e.g., U.S. Pat No. 6,093,581, Example 1);
• Solar Cell 2 is a 10x10 in (254x254 mm) copper indium diselenide (CIS) photovoltaic device (see, e.g., U.S. Pat No. 6,353,042, column 6, line 19);
• Solar Cell 3 is a 10x10 in (254x254 mm) cadmium telluride (CdTe) photovoltaic device (see, e.g., U.S. Pat No. 6,353,042, column 6, line 49);
• Solar Cell 4 is a silicon solar cell made from a 10x10 in (254x254 mm) polycrystalline EFG-grown wafer (see, e.g., U.S. Pat No. 6,660,930, column 7, line 61);
• TPT is a Akasol^{®} PTL 3-38/75 film layer (Akasol^{®} film layer; August Krempel Soehne GmbH & Co., Germany) described as a 7 mil thick white poly(vinylidene fluoride)/poly(ethylene terephthalate)/poly(vinylidene fluoride) tri-layer film with primer.

### Examples 1-12 (for Reference)

A series of 12x12 in (305x305 mm) laminate structures described below in Table 1 are assembled and laminated by Lamination Process 1. For all examples an acid terpolymer surface of the interlayer is in contact with the tin side of the glass sheet. For Examples 7 and 11, the coated surface of the poly(ethylene terephthalate) film is in contact with the acid terpolymer film or sheet.

### Examples 13-24 (for Reference)

A series of 12x12 in (305x305 mm) laminate structures described below in Table 1 are assembled and laminated by Lamination Process 2. For all examples an acid terpolymer surface of the interlayer is in contact with the tin side of the glass sheet. For Examples 19 and 23, the coated surface of the poly(ethylene terephthalate) film is in contact with the acid terpolymer film or sheet.

**TABLE 1**

| | Laminate Structures | | | | |
|---|---|---|---|---|---|
| Example | Layer 1 | Layer 2 | Layer 3 | Layer 4 | Layer 5 |
| 1, 13 | Glass 1 | ATR 1 | Glass 1 | | |
| 2,14 | Glass 2 | ATR 1 | PET 1 | | |
| 3, 15 | Glass 1 | ATR 2 | Glass 1 | | |
| 4,16 | Glass 3 | ATR2 | PET 1 | | |
| 5, 17 | Glass 1 | ATR3 | PET 2 | ATR 3 | Glass 1 |
| 6, 18 | Glass 1 | ATR 4 | Glass 1 | | |
| 7,19 | Glass 2 | ATR4 | PET 3 | | |
| 8,20 | Glass 3 | ATR 5 | PET 4 | ATR 5 | Glass 1 |
| 9, 21 | Glass 1 | ATR6 | PET 5 | PVB-A | Glass 1 |
| 10,22 | Glass 1 | ATR 7 | ION 1 | ATR 7 | Glass 1 |
| 11, 23 | Glass 2 | ATR 8 | EBA | ATR 8 | PET6 |
| 12,24 | Glass 1 | ATR9 | ION 2 | ATR 8 | Glass 1 |

### Examples 25-38

A series of 12x12 in (305x305 mm) solar cell laminate structures described below in Table 2 are assembled and laminated by Lamination Process 1. Layers 1 and 2 constitute the incident layer and the front encapsulant layer, respectively, and Layers 4 and 5 constitute the back encapsulant layer and the backing layer, respectively.

### Examples 39-52

A series of 12x12 in (305x305 mm) solar cell laminate structures described below in Table 2 are assembled and laminated by Lamination Process 2. Layers 1 and 2 constitute the incident layer and the front encapsulant layer, respectively, and Layers 4 and 5 constitute the back encapsulant layer and the backing layer, respectively.

**TABLE 2**

| | Laminate Structures | | | | |
|---|---|---|---|---|---|
| Example | Layer 1 | Layer 2 | Layer 3 | Layer 4 | Layer 5 |
| 25, 39 | Glass 4 | ATR 3 | Solar Cell 1 | ATR 3 | FPF |
| 26, 40 | Glass 4 | ATR 3 | Solar Cell 2 | ATR 1 | Glass 1 |
| 27,41 | Glass 4 | ATR 5 | Solar Cell 3 | ATR 5 | TPT |
| 28, 42 | Glass 4 | ATR 5 | Solar Cell 4 | ATR 2 | Glass 1 |
| 29, 43 | FPF | ATR 6 | Solar Cell 1 | ATR 6 | AL |
| 30, 44 | Glass 4 | EVA | Solar Cell 2 | ATR 4 | Glass 1 |
| 31,45 | FPF | ATR 10 | Solar Cell 1 | ATR 10 | FPF |
| 32, 46 | Glass 1 | ATR 10 | Solar Cell 2 | PVB | PET 1 |
| 33,47 | Glass 4 | ATR 11 | Solar Cell 3 | ATR 11 | TPT |
| 34,48 | Glass 4 | ATR 11 | Solar Cell 4 | ION 2 | AL |
| 35, 49 | Glass 4 | ION 2 | Solar Cell 1 | ATR 11 | Glass 1 |
| 36, 50 | Glass 4 | ATR 12 | Solar Cell 2 | ATR 12 | FPF |
| 37, 51 | Glass 4 | ATR 12 | Solar Cell 1 | PVB-A | Glass 1 |
| 38.52 | Glass 4 | ATR 12 | Solar Cell 4 | ION 1 | |

## Claims

1. A solar cell pre-lamination assembly comprising
(a) a solar cell component formed of one or a plurality of electronically interconnected solar cells and having a light-receiving side that faces a light source and a back side that is opposite from the light source, and
(b) a film or sheet;
**characterized in that**
the film or sheet comprises or is made of an acid terpolymer composition; and
the acid terpolymer comprises copolymerized units derived from an α-olefin, 15 to 30 wt% of an α,β-ethylenically unsaturated carboxylic acid having 3 to 8 carbons, and 0.5 to 40 wt% of an α,β-ethylenically unsaturated carboxylic acid ester having 4 to 12 carbons, based on the total weight of the acid terpolymer,
provided that the acid terpolymer does not have a Melt Index of 75 to 600 g/10 min as measured by ASTM D1238 at 190°C and a 2160 g load.

2. The assembly of claim 1 wherein said film or sheet is a single-layer film or sheet.

3. The assembly of claim 1 wherein
the acid terpolymer comprises 18 to 25 wt%, preferably 18 to 23 wt%, of copolymerized units of the α,β-ethylenically unsaturated carboxylic acid and 0.5 to 5 wt%, or 15 to 40 wt%, of copolymerized units of the α,β-ethylenically unsaturated carboxylic acid ester, based on the total weight of the terpolymer;
the film or sheet is a multilayer structure comprising a first surface sub-layer, a second surface sub-layer, and optionally one or more inner sub-layers;
the first surface sub-layers comprises or is made of the film or sheet and each of the other sub-layer(s) comprises or is made of acid copolymer, ionomer, ethylene vinyl acetate, poly(vinyl acetal), polyurethane, polyvinylchloride, polyethylene, polyolefin block elastomer, poly(α-olefin-co-α,β-ethylenically unsaturated carboxylic acid ester) copolymer, silicone elastomer, epoxy resin, or combinations of two or more thereof.

4. The assembly of claim 3 wherein
the film or sheet comprises a second surface sub-layer, at least one of the optional inner sub-layer(s), or both, comprises or is formed of an ionomer having a melting point of at least about 80°C, preferably at least about 90°C; and
the second surface sub-layer comprises or is made of the film or sheet.

5. The assembly of claim 3 or 4 wherein the film or sheet has a total thickness of 0.051 mm to 6.35 mm; the first surface sub-layer, the second surface sub-layer, or both has a thickness of 0.013 mm to 0.13 mm; each of the inner sub-layer(s) has a thickness of 0.013 mm to 3 mm.

6. The assembly of claim 1 wherein
the assembly comprises a front encapsulant layer positioned next to the light-receiving side of the solar cell component and a back encapsulant layer positioned next to the back side of the solar cell component;
the front encapsulant layer is formed of the film or sheet having a thickness of 0.051 mm to 0.51 mm; and
the back encapsulant layer comprises or is formed of acid copolymer, ionomer, ethylene vinyl acetate, poly(vinyl acetal), polyurethane, polyvinylchloride, polyethylene, polyolefin block elastomer, poly(α-olefin-co-α,β-ethylenically unsaturated carboxylic acid ester) copolymer, silicone elastomer, epoxy resin, or combinations of two or more thereof.

7. The assembly of any one of the preceding claims further comprising an incident layer positioned next to the front encapsulant layer and a backing layer positioned next to the back encapsulant layer wherein
the incident layer is (i) glass sheet, (ii) polymeric sheet, or (iii) polymeric film;
the polymeric sheet comprises or is formed of polycarbonate, acrylic, polyacrylate, cyclic polyolefin, polystyrene, polyamide, polyester, fluoropolymer, or combinations of two or more thereof; and
the polymeric film comprises or is formed of polyester, polycarbonate, polyolefin, norbornene polymer, polystyrene, styrene-acrylate copolymer, acrylonitrile-styrene copolymer, polysulfone, nylon, polyurethane, acrylic, cellulose acetate, cellophane, poly(vinyl chloride), fluoropolymer, or combinations of two or more thereof.

8. The assembly of any one of the preceding claims wherein the front encapsulant layer and the back encapsulant layer both comprise or are formed of the film or sheet.

9. The assembly of any one of the preceding claims wherein
the backing layer is (i) glass sheet, (ii) polymeric sheet, (iii) polymeric film, (iv) metal sheet, or (v) ceramic plate;
the polymeric sheet comprises or is formed of polycarbonate, acrylics, polyacrylate, cyclic polyolefin, polystyrene, polyamide, polyester, fluoropolymer, or combinations or two or more thereof; and
the polymeric film comprises or is formed of polyester, polycarbonate, polyolefin, norbornene polymer, polystyrene, styrene-acrylate copolymer, acrylonitrile-styrene copolymer, polysulfone, nylon, polyurethane, acrylic, cellulose acetate, cellophanes, poly(vinyl chloride), fluoropolymer, or combinations of two or more thereof.

10. The assembly of any one of the preceding claims consisting essentially of, from a top side that faces the light source to a bottom side that is opposite from the light source, (i) an incident layer that is positioned next to, (ii) a front encapsulant layer that is positioned next to, (iii) the solar cell component that is positioned next to, (iv) a back encapsulant layer that is positioned next to, (v) a backing layer, wherein the front encapsulant layer or the back encapsulant layers, or both, is formed of the film or sheet.

11. The assembly of any one of the preceding claims, wherein the acid terpolymer composition further comprises one or more additives, such as plasticizers, processing aides, lubricants, flame retardants, impact modifiers, nucleating agents, antiblocking agents, thermal stabilizers, UV, absorbers, UV stabilizers, dispersants, surfactants, chelating agents, coupling agents, adhesives, primers, or mixtures of two or more thereof.

12. A process comprising: (i) providing a solar cell pre-lamination assembly and (ii) laminating the assembly to form a solar cell module, wherein the assembly is the article **characterized in** any one of claims 1 to 10 and the laminating is preferably conducted by subjecting the assembly to heat.

13. The process of claim 12 wherein the laminating further comprises subjecting the assembly to vacuum or pressure.

14. A solar cell module comprising or produced from a solar cell pre-lamination assembly, wherein the assembly is the article **characterized in** any one of claims 1 to 11 and, preferably, after the module has been conditioned for 1000 hours at a temperature of about 85°C and a relative humidity of about 85%, at least about 75% of the 180° peel strength between the terionomer multilayer film or sheet and its adjacent layer(s) is maintained.

15. The assembly of any one of claims 1 to 11 wherein the solar cell is multi-crystalline solar cell, thin film solar cell, compound semiconductor solar cell, amorphous silicon solar cell, or combinations of two or more thereof.

## Patentansprüche

1. Solarzellen-Vorlaminierungsbaugruppe, die aufweist:
(a) eine Solarzellenkomponente, die aus einer oder mehreren, elektronisch miteinander verbundenen Solarzellen besteht und eine Lichtempfangsseite, die einer Lichtquelle zugewandt ist, sowie eine von der Lichtquelle abgewandte Rückseite aufweist, und
(b) einen Film oder eine Folie;
**dadurch gekennzeichnet, dass**
der Film oder die Folie eine Säureterpolymer-Zusammensetzung aufweist oder daraus besteht; und
das Säureterpolymer von einem α-Olefin abgeleitete copolymerisierte Einheiten, 15 bis 30 Gew.-% einer α,β-ethylenisch ungesättigten Carbonsäure mit 3 bis 8 Kohlenstoffatomen und 0,5 bis 40 Gew.-% eines α,β-ethylenisch ungesättigten Carbonsäureesters mit 4 bis 12 Kohlenstoffatomen aufweist, bezogen auf das Gesamtgewicht des Säureterpolymers,
vorausgesetzt, dass das Säureterpolymer keinen Schmelzindex von 75 bis 600 g/10 min aufweist, gemessen nach ASTM D1238 bei 190°C und einer Last von 2160 g.

2. Baugruppe nach Anspruch 1, wobei der Film oder die Folie ein einschichtiger Film oder eine einschichtige Folie ist.

3. Baugruppe nach Anspruch 1, wobei
das Säureterpolymer 18 bis 25 Gew.-%, vorzugsweise 18 bis 23 Gew.-% copolymerisierte Einheiten der α, β -ethylenisch ungesättigten Carbonsäure und 0,5 bis 5 Gew.-% oder 15 bis 40 Gew.-% copolymerisierte Einheiten des α, β -ethylenisch ungesättigten Carbonsäureesters aufweist, bezogen auf das Gesamtgewicht des Terpolymers;
der Film oder die Folie eine mehrschichtige Struktur ist, die eine erste Oberflächenteilschicht, eine zweite Oberflächenteilschicht und wahlweise eine oder mehrere innere Teilschichten aufweist;
die erste Oberflächenteilschicht den Film oder die Folie aufweist oder daraus besteht, und jede der anderen Teilschicht(en) Säurecopolymer, Ionomer, Ethylenvinylacetat, Poly(vinylacetal), Polyurethan, Polyvinylchlorid, Polyethylen, Polyolefin-Blockelastomer, Poly(α-olefin-co-α,β-ethylenisch ungesättigtem Carbonsäureester)-Copolymer, Silicon-Elastomer, Epoxidharz oder Kombinationen von zwei oder mehreren dieser Verbindungen aufweist oder daraus besteht.

4. Baugruppe nach Anspruch 3, wobei
der Film oder die Folie eine zweite Oberflächenteilschicht, mindestens eine der wahlfreien inneren Teilschicht(en) oder beide aufweist, ein Ionomer mit einem Schmelzpunkt von mindestens etwa 80°C, vorzugsweise mindestens etwa 90°C aufweist oder daraus besteht; und
die zweite Oberflächenteilschicht den Film oder die Folie aufweist oder daraus besteht.

5. Baugruppe nach Anspruch 3 oder 4, wobei der Film oder die Folie eine Gesamtdicke von 0,051 mm bis 6,35 mm aufweist, die erste Oberflächenteilschicht, die zweite Oberflächenteilschicht oder beide eine Dicke von 0,013 mm bis 0,13 mm aufweisen, und jede der inneren Teilschicht(en) eine Dicke von 0,013 mm bis 3 mm aufweist.

6. Baugruppe nach Anspruch 1, wobei
die Baugruppe eine vordere Kapselungsmaterialschicht, die angrenzend an die Lichtempfangsseite der Solarzellenkomponente angeordnet ist, und eine hintere Kapselungsmaterialschicht aufweist, die angrenzend an die Rückseite der Solarzellenkomponente angeordnet ist;
die vordere Kapselungsmaterialschicht aus dem Film oder der Folie mit einer Dicke von 0,051 mm bis 0,51 mm geformt ist; und
die hintere Kapselungsmaterialschicht Säurecopolymer, Ionomer, Ethylenvinylacetat, Poly(vinylacetal), Polyurethan, Polyvinylchlorid, Polyethylen, Polyolefin-Blockelastomer, Poly(α-olefin-co-α,β-ethylenisch ungesättigten Carbonsäureester)-Copolymer, Silicon-Elastomer, Epoxidharz oder Kombinationen von zwei oder mehreren dieser Verbindungen aufweist oder daraus besteht.

7. Baugruppe nach einem der vorstehenden Ansprüche, die ferner eine angrenzend an die vordere Kapselungsmaterialschicht angeordnete Eintrittsschicht und eine angrenzend an die hintere Kapselungsmaterialschicht angeordnete Verstärkungsschicht aufweist, wobei
die Eintrittsschicht (i) Glasfolie, (ii) Polymerfolie oder (iii) ein Polymerfilm ist; die Polymerfolie Polycarbonat, Acrylharz, Polyacrylharz, cyclisches Polyolefin, Polystyrol, Polyamid, Polyester, Fluorpolymer oder Kombinationen von zwei oder mehr dieser Verbindungen aufweist oder daraus besteht; und
der Polymerfilm Polyester, Polycarbonat, Polyolefin, Norbornen-Polymer, Polystyrol, Styrol-Acrylat-Copolymer, Acrylnitril-Styrol-Copolymer, Polysulfon, Nylon, Polyurethan, Acrylharz, Celluloseacetat, Cellophan, Poly(vinylchlorid), Fluorpolymer oder Kombinationen von zwei oder mehr dieser Verbindungen aufweist oder daraus besteht.

8. Baugruppe nach einem der vorstehenden Ansprüche, wobei die vordere Kapselungsmaterialschicht und die hintere Kapselungsmaterialschicht beide den Film oder die Folie aufweisen oder daraus bestehen.

9. Baugruppe nach einem der vorstehenden Ansprüche, wobei
die Verstärkungsschicht (i) Glasfolie, (ii) Polymerfolie, (iii) ein Polymerfilm, (iv) Metallfolie oder (v) eine Keramikplatte ist;
die Polymerfolie Polycarbonat, Acrylharz, Polyacrylharz, cyclisches Polyolefin, Polystyrol, Polyamid, Polyester, Fluorpolymer oder Kombinationen von zwei oder mehr dieser Verbindungen aufweist oder daraus besteht; und
der Polymerfilm Polyester, Polycarbonat, Polyolefin, Norbornen-Polymer, Polystyrol, Styrol-Acrylat-Copolymer, Acrylnitril-Styrol-Copolymer, Polysulfon, Nylon, Polyurethan, Acrylharz, Celluloseacetat, Cellophan, Poly(vinylchlorid), Fluorpolymer oder Kombinationen von zwei oder mehr dieser Verbindungen aufweist oder daraus besteht.

10. Baugruppe nach einem der vorstehenden Ansprüche, die von einer der Lichtquelle zugewandten Oberseite bis zu einer von der Lichtquelle abgewandten Unterseite im Wesentlichen aus den folgenden Schichten besteht: (i) einer Eintrittsschicht, die angrenzt an (ii) eine vordere Kapselungsmaterialschicht, die angrenzt an (iii) die Solarzellenkomponente, die angrenzt an (iv) eine hintere Kapselungsmaterialschicht, die angrenzt an (v) eine Verstärkungsschicht, wobei die vordere Kapselungsmaterialschicht oder die hintere Kapselungsmaterialschicht oder beide aus dem Film oder der Folie geformt werden.

11. Baugruppe nach einem der vorstehenden Ansprüche, wobei die Säureterpolymer-Zusammensetzung ferner einen oder mehrere Zusätze aufweist, wie z. B. Weichmacher, Verarbeitungshilfsmittel, Gleitmittel, Flammverzögerungsmittel, schlagzähmachende Zusatzstoffe, Keimbildner, Antiblockmittel, Thermostabilisatoren, UV-Absorber, UV-Stabilisatoren, Dispergiermittel, Tenside, Chelatbildner, Haftvermittler, Haftmittel, Primer oder Gemische von zwei oder mehreren dieser Verbindungen.

12. Verfahren, das aufweist (i) Bereitstellen einer Solarzellen-Vorlaminierungsbaugruppe und (ii) Laminieren der Baugruppe, um ein Solarzellenmodul zu formen, wobei die Baugruppe der in einem der Ansprüche 1 bis 10 charakterisierte Artikel ist und das Laminieren vorzugsweise durchgeführt wird, indem die Baugruppe Hitze ausgesetzt wird.

13. Verfahren nach Anspruch 12, wobei das Laminieren ferner die Anwendung von Unterdruck oder Druck auf die Baugruppe aufweist.

14. Solarzellenmodul, der eine Solarzellenvorlaminierungsbaugruppe aufweist oder daraus hergestellt wird, wobei die Baugruppe der in einem der Ansprüche 1 bis 11 charakterisierte Artikel ist, und wobei, vorzugsweise nachdem das Modul 1000 Stunden bei einer Temperatur von etwa 85°C und einer relativen Feuchte von etwa 85% konditioniert worden ist, mindestens etwa 75% der Haftfestigkeit bei 180° zwischen dem mehrschichtigen Terionomerfilm bzw. der mehrschichtigen Terionomerfolie und der (den) daran angrenzenden Schicht(en) erhalten bleiben.

15. Baugruppe nach einem der Ansprüche 1 bis 11, wobei die Solarzelle eine polykristalline Solarzelle, Dünnfilmsolarzelle, Verbindungshalbleitersolarzelle, Solarzelle aus amorphem Silizium oder eine Kombination von zwei oder mehreren dieser Solarzellen ist.

## Revendications

1. Assemblage de pré-stratification de cellule solaire comprenant:
(a) un composant de cellule solaire formé d'une ou de plusieurs cellules solaires électroniquement interconnectées et possédant un côté de réception de lumière qui fait face à une source de lumière et un côté arrière qui est opposé par rapport à la source de lumière, et
(b) un film ou une feuille;
**caractérisé en ce que**:
le film ou la feuille comprend ou est formé d'une composition de terpolymère acide; et
le terpolymère acide comprend des unités copolymérisées dérivées d'une oléfine α, de 15 à 30% en poids d'un acide carboxylique α,β-éthyléniquement insaturé possédant de 3 à 8 carbones et de 0,5 à 40% en poids d'un ester d'acide carboxylique α,β-éthyléniquement insaturé possédant de 4 à 12 carbones, sur la base du poids total du terpolymère acide,
à condition que le terpolymère acide ne présente pas un indice de fusion de 75 à 600 g/10 min lorsqu'il est mesuré par la norme ASTM D1238 à 190°C et une charge de 2160 g.

2. Assemblage selon la revendication 1, dans lequel ledit film ou ladite feuille est un film ou une feuille monocouche.

3. Assemblage selon la revendication 1, dans lequel:
le terpolymère acide comprend de 18 à 25% en poids, de préférence de 18 à 23% en poids, d'unités copolymérisées de l'acide carboxylique α,β-éthyléniquement insaturé et de 0,5 à 5% en poids, ou de 15 à 40% en poids, d'unités copolymérisées de l'ester d'acide carboxylique α,β-éthyléniquement insaturé, sur la base du poids total du terpolymère,
le film ou la feuille est une structure multicouche comprenant une première sous-couche de surface, une deuxième sous-couche de surface et éventuellement une ou plusieurs sous-couches internes;
la première sous-couche de surface comprend ou est formée du film ou de la feuille et chacune de la ou des autres sous-couches comprend ou est formée d'un copolymère acide, d'un ionomère, d'un éthylène-acétate de vinyle, d'un poly(vinylacétal), d'un polyuréthane, d'un polyvinylchlorure, d'un polyéthylène, d'un élastomère bloc de polyoléfine, d'un copolymère de poly(oléfine α-co-ester d'acide carboxylique α,β-éthyléniquement insaturé), d'un élastomère de silicone, d'une résine époxy ou de combinaisons de deux ou plus de ceux-ci.

4. Assemblage selon la revendication 3, dans lequel:
le film ou la feuille comprend une deuxième sous-couche de surface, au moins une de la ou des sous-couches internes éventuelles, ou les deux, comprend ou est formé d'un ionomère présentant un point de fusion d'au moins environ 80°C, de préférence au moins environ 90°C; et
la deuxième sous-couche de surface comprend ou est formée du film ou de la feuille.

5. Assemblage selon la revendication 3 ou 4, dans lequel le film ou la feuille possède une épaisseur totale de 0,051 mm à 6,35 mm; la première sous-couche de surface, la deuxième sous-couche de surface, ou les deux, possède une épaisseur de 0,013 mm à 0,13 mm; chacune de la ou des sous-couches internes possède une épaisseur de 0,013 mm à 3 mm.

6. Assemblage selon la revendication 1, dans lequel:
l'assemblage comprend une couche encapsulante avant positionnée à la suite du côté de réception de lumière du composant de cellule solaire et une couche encapsulante arrière positionnée à la suite du côté arrière du composant de cellule solaire;
la couche encapsulante avant est formée du film ou de la feuille possédant une épaisseur de 0,051 mm à 0,51 mm; et
la couche encapsulante arrière comprend ou est formée d'un copolymère acide, d'un ionomère, d'un éthylène-acétate de vinyle, d'un poly(vinylacétal), d'un polyuréthane, d'un polyvinylchlorure, d'un polyéthylène, d'un élastomère bloc de polyoléfine, d'un copolymère de poly(oléfine α-co-ester d'acide carboxylique α,β-éthyléniquement insaturé), d'un élastomère de silicone, d'une résine époxy ou de combinaisons de deux ou plus de ceux-ci.

7. Assemblage selon l'une quelconque des revendications précédentes, comprenant en outre une couche incidente positionnée à la suite de la couche encapsulante avant et une couche de renforcement positionnée à la suite de la couche encapsulante arrière, dans lequel:
la couche incidente est (i) une feuille de verre, (ii) une feuille polymère ou (iii) un film polymère;
la feuille polymère comprend ou est formée d'un polycarbonate, d'un acrylique, d'un polyacrylate, d'une polyoléfine cyclique, d'un polystyrène, d'un polyamide, d'un polyester, d'un fluoropolymère ou de combinaisons de deux ou plus de ceux-ci; et
le film polymère comprend ou est formé d'un polyester, d'un polycarbonate, d'une polyoléfine, d'un polymère de norbornène, d'un polystyrène, d'un copolymère de styrène-acrylate, d'un copolymère d'acrylonitrile-styrène, d'une polysulfone, d'un nylon, d'un polyuréthane, d'un acrylique, d'un acétate de cellulose, d'un cellophane, d'un poly(vinylchlorure), d'un fluoropolymère ou de combinaisons de deux ou plus de ceux-ci.

8. Assemblage selon l'une quelconque des revendications précédentes, dans lequel la couche encapsulante avant et la couche encapsulante arrière toutes les deux comprennent ou sont formées du film ou de la feuille.

9. Assemblage selon l'une quelconque des revendications précédentes, dans lequel:
la couche de renforcement est (i) une feuille de verre, (ii) une feuille polymère, (iii) un film polymère, (iv) une feuille métallique ou (v) une plaque céramique;
la feuille polymère comprend ou est formée d'un polycarbonate, d'un acrylique, d'un polyacrylate, d'une polyoléfine cyclique, d'un polystyrène, d'un polyamide, d'un polyester, d'un fluoropolymère ou de combinaisons de deux ou plus de ceux-ci; et
le film polymère comprend ou est formé d'un polyester, d'un polycarbonate, d'une polyoléfine, d'un polymère de norbornène, d'un polystyrène, d'un copolymère de styrène-acrylate, d'un copolymère d'acrylonitrile-styrène, d'une polysulfone, d'un nylon, d'un polyuréthane, d'un acrylique, d'un acétate de cellulose, de cellophanes, d'un poly(vinylchlorure), d'un fluoropolymère ou de combinaisons de deux ou plus de ceux-ci.

10. Assemblage selon l'une quelconque des revendications précédentes, constitué essentiellement de, d'un côté du dessus qui fait face à la source de lumière à un côté du dessous qui est opposé par rapport à la source de lumière, (i) une couche incidente qui est positionnée à la suite (ii) d'une couche encapsulante avant qui est positionnée à la suite (iii) du composant de cellule solaire qui est positionné à la suite (iv) d'une couche encapsulante arrière qui est positionnée à la suite (v) d'une couche de renforcement, dans lequel la couche encapsulante avant ou la couche encapsulante arrière, ou les deux, est formée du film ou de la feuille.

11. Assemblage selon l'une quelconque des revendications précédentes, dans lequel la composition de terpolymère acide comprend en outre un ou plusieurs additifs, tels que des plastifiants, des auxiliaires de mise en oeuvre, des lubrifiants, des produits ignifuges, des agents antichoc, des agents de nucléation, des agents anti-bloquants, des stabilisants thermiques, des absorbeurs UV, des stabilisants UV, des dispersants, des tensioactifs, des agents de chélation, des agents de couplage, des adhésifs, des apprêts ou des mélanges de deux ou plus de ceux-ci.

12. Procédé comprenant: (i) la fourniture d'un assemblage de pré-stratification de cellule solaire et (ii) la stratification de l'assemblage pour former un module de cellule solaire, dans lequel l'assemblage est l'article caractérisé dans l'une quelconque des revendications 1 à 10 et la stratification est conduite de préférence en soumettant l'assemblage à de la chaleur.

13. Procédé selon la revendication 12, dans lequel la stratification consiste en outre à soumettre l'assemblage à un vide ou une pression.

14. Module de cellule solaire comprenant ou produit à partir d'un assemblage de pré-stratification de cellule solaire, dans lequel l'assemblage est l'article caractérisé dans l'une quelconque des revendications 1 à 11 et, de préférence, après le conditionnement du module pendant 1000 heures à une température d'environ 85°C et une humidité relative d'environ 85%, au moins environ 75% de la résistance au pelage à 180° entre le film ou la feuille muticouche de ter-ionomère et de sa ou ses couches adjacentes est maintenue.

15. Assemblage selon l'une quelconque des revendications 1 à 11, dans lequel la cellule solaire est une cellule solaire multi-cristalline, une cellule solaire à film mince, une cellule solaire à semi-conducteurs composés, une cellule solaire de silicium amorphe ou des combinaisons de deux ou plus de celles-ci.
